# EUROPÄISCHE PATENTANMELDUNG

(11) **EP 3 893 267 A2**
(43) Veröffentlichungstag der Anmeldung: **13.10.2021**
(21) Anmeldenummer: 21020228.9
(22) Anmeldetag: 25.04.2012
(51) Int. Cl.: H01L 21/02

(54) **MONOLITHISCHE INTEGRIERTE HALBLEITERSTRUKTUR**

(30) Priorität: 12.07.2011 DE 102011107657
(62) Teilanmeldung aus: 12740874.8
(71) Anmelder: NASP III/V GmbH, 35041 Marburg (DE)
(72) Erfinder: Kunert, Bernadette, 35041 Marburg (DE)
(74) Vertreter: Jungblut & Seuss

(57) **Zusammenfassung**

Die Erfindung betrifft eine monolithische integrierte Halbleiterstruktur enthaltend den folgenden Schichtaufbau: A) eine Trägerschicht auf Basis dotiertem oder undotiertem Si, B) optional einer Schicht mit der Zusammensetzung BₓAl_{y}Ga_{z}NₜPᵥ, wobei x=0-0,1, y=0-1, z=0-1, t=0-0,1 und v=0,9-1 C) einer Relaxationsschicht mit der Zusammensetzung BₓAl_{y}Ga_{z}InᵤPᵥSb_{w}, wobei x=0-0,1, y=0-1, z=0-1, u=0-1, v=0-1 und w=0-1, wobei w und/oder u auf der der Schicht A) oder B) zugewandten Seite kleiner, gleich, oder größer als auf der der Schicht A) oder B) abgewandten Seite ist, und wobei v=1-w und/oder y=1-u-x-z, D) optional einer Schicht zur Blockierung von Fehlversetzungen mit der Zusammensetzung BₓAl_{y}Ga_{z}InᵤPᵥSb_{w}Nₜ, wobei x=0-0,1, y=0-1, z=0-1, u=0-1, v=0-1, w=0-1 und t=0-0,1, E) optional einer Schicht zum Hetero-offset mit der Zusammensetzung BₓAl_{y}Ga_{z}InᵤPᵥSb_{w}NₜASᵣ wobei x=0-0,1, y=0-1, z=0-1, u=0-1, v=0-1, w=0-1, t=0-0,1 und r=0-1, und F) ein beliebiges, vorzugsweise Gruppe III/V, Halbleitermaterial, oder eine Kombination von mehreren verschiedenen beliebigen Halbleitermaterialien, wobei die vorstehenden stöchiometrischen Indizes für alle Gruppe III Elemente in der Summe stets 1 ergeben und wobei die vorstehenden stöchiometrischen Indizes für alle Gruppe V Elemente in der Summe ebenfalls stets 1 ergeben.

## Beschreibung

### Gebiet der Erfindung

Die Erfindung betrifft eine monolithische integrierte Halbleiterstruktur, welche zur Bildung von integrierten Halbleiterbauelementen auf Basis der Gruppe III/V Elemente auf einem Siliziumsubstrat geeignet sind, ein Verfahren zu dessen Herstellung sowie deren Verwendungen

### Hintergrund der Erfindung und Stand der Technik

Die Erfindung des integrierten Schaltkreises auf der Basis von Silizium und Siliziumdioxid hat in den letzten Jahrzehnten eine enorme Entwicklung in der Mikrochip-Prozessor- Technologie bzw. Mikroelektronik ermöglicht. In einem integrierten Schaltkreis werden u.a. n-Kanal und p-Kanal-Transistoren für die Datenverarbeitung in der sogenannten CMOS-Logik (Englisch: Complementary metaloxid-semiconductor) verschaltet. Transistoren sind im Wesentlichen Widerstände, die durch eine äußere Gate-Spannung gesteuert werden. In den letzten Jahrzehnten konnte die Leistung der integrierten Schaltkreise durch zunehmende Miniaturisierung der Transistoren und daraus folgend durch die steigende Transistordichte verbessert werden. Mittlerweile sind jedoch die einzelnen Strukturen der Transistor-Bauelemente in den Dimensionen so klein, dass grundlegende physikalische Grenzen auftreten und eine weitere Miniaturisierung zu keiner Verbesserung der Schaltkreise führt.

An dieser Stelle werden neben Silizium und Siliziumdioxid inzwischen neue Materialien bei der Herstellung von integrierten Schaltkreisen eingesetzt, deren physikalischen Eigenschaften zu einer Verbesserung der Funktionsweise führen. U.a. wird auch der Einsatz von III/V Halbleitermaterialien in der CMOS Technologie diskutiert.

Da die Elektronenmobilität von einigen III/V Halbleitermaterialien wesentlich höher ist als die von Silizium und die Effizienz bzw. Schaltgeschwindigkeit von n-Kanal-Transistoren u.a. maßgeblich von der Elektronenmobilität bestimmt wird, könnte der Einsatz von III/V Halbleitermaterialien als n-Kanalschichten zu einer wesentlichen Verbesserung der integrierten Schaltkreise führen. Desweiteren kann die Gate-Spannung durch die Anwendung von III/V Halbleitermaterialien reduziert werden, was wiederum den Energieverbrauch und folglich die Wärmedissipation in den integrierten Schaltkreisen vermindert. Derzeit werden von verschiedenen Instituten, Universitäten und Firmen die Anwendung von III/V Kanalschichten in der Silizium-Technologie untersucht.

Welcher III/V Halbleiter optimal für die Integration auf Silizium ist, wird einerseits durch die grundlegenden Eigenschaften des Halbleitermaterials bestimmt, wie z.B. die Elektronenmobilität und die elektronische Bandlücke.

Andererseits muss letztendlich die Kompatibilität zur Massenproduktion in der Silizium-Technologie berücksichtigt werden. Arsen ist ein wesentlicher Bestandteil vieler III/V Halbleitermischkristalle. Aufgrund der hohen Toxizität von Arsen erfordert eine mögliche Anwendung arsenhaltiger Materialien in einer groß-industriellen Produktion eine aufwendige Entsorgung der arsenhaltigen Abfallprodukte.

Bei der Integration von III/V Halbleitermaterialen auf Silizium basierte Schaltkreise wird üblicherweise mit dem Epitaxieverfahren gearbeitet. In diesem epitaktischen Abscheidungsverfahren spielen die Gitterkonstanten der kristallinen Halbleitermaterialien eine entscheidende Rolle. Das verwendete Siliziumsubstrat bzw. das Trägersubstrat in der Silizium-Chip-Technologie gibt die zugrunde liegende Gitterkonstante vor. Die meisten III/V Halbleitermaterialien mit hoher Elektronenmobilität besitzen jedoch eine andere Gitterkonstante wie Silizium, die üblicherweise größer ist. Dieser Unterschied in den Gitterkonstanten führt bei der epitaktischen Integration von III/V-Kanalschichten auf Siliziumsubstrat zur Ausbildung von Fehlversetzungen in der III/V-Halbleiterschicht. Diese Versetzungen sind Kristalldefekte, die maßgeblich die elektronischen Eigenschaften der Halbleiterschicht verschlechtern. Um eine optimale Materialqualität der III/V Kanalschichten zu gewährleisten, sind spezielle III/V-Pufferschichten notwendig. Diese Pufferschichten definieren sich durch eine spezielle Abfolgen von unterschiedlichen III/V Halbleitermaterialien und/oder durch ein spezielles Herstellungsverfahren. Des Weiteren darf diese Pufferschicht nicht zu dick sein, damit die Kompatibilität in der III/V-Integration auf Silizium zum aktuellen CMOS-Prozess gewährleistet ist.

Verschiedene Pufferschichten bzw. Anpassungsschichten sind beispielsweise aus der Literaturstelle DE 103 55 357 A bekannt.

### Technisches Problem der Erfindung

Der Erfindung liegt das technische Problem zu Grunde, eine integrierte monolithische Halbleiterstruktur anzugeben, welche Gruppe III/V Halbleiter auf Siliziumsubstrate integriert, und zwar unter Erfüllung aller elektronischen Anforderungen, unter Vermeidung oder Reduktion von Arsenhaltigen Abfällen während der Produktion sowie unter optimierter Anpassung unterschiedlicher Gitterkonstanten von Silizium einerseits und Gruppe III/V Halbleitern andererseits.

### Grundzüge der Erfindung

Zur Lösung dieses technischen Problems lehrt die Erfindung Monolithische integrierte Halbleiterstruktur enthaltend den folgenden Schichtaufbau: A) eine Trägerschicht auf Basis dotiertem oder undotiertem Si, B) optional einer Schicht mit der Zusammensetzung BₓAl_{y}Ga_{z}NₜPᵥ, wobei x=0-0,1, y=0-1, z=0-1, t=0-0,1 und v=0,9-1 C) einer Relaxationsschicht mit der Zusammensetzung BₓAl_{y}Ga_{z}InᵤPᵥSb_{w}, wobei x=0-0,1, y=0-1, z=0-1, u=0-1, v=0-1 und w=0-1, wobei w und/oder u auf der der Schicht A) oder B) zugewandten Seite kleiner, gleich, oder größer als auf der der Schicht A) oder B) abgewandten Seite ist und innerhalb der Relaxationsschicht variable oder konstant ist, und wobei v=1-w und/oder 1=u+x+y+z, D) optional einer Schicht zur Blockierung von Fehlversetzungen mit der Zusammensetzung BₓAl_{y}Ga_{z}InᵤPᵥSb_{w}Nₜ, wobei x=0-0,1, y=0-1, z=0-1, u=0-1, v=0-1, w=0-1 und t=0-0,1, E) optional einer Schicht zum Hetero-offset mit der Zusammensetzung BₓAl_{y}Ga_{z}InᵤPᵥSb_{w}NₜAsᵣ wobei x=0-0,1, y=0-1, z=0-1, u=0-1, v=0-1, w=0-1, t=0-0,1 und r=0-1, und F) ein beliebiges Gruppe III/V Halbleitermaterial oder die Kombination von mehreren beliebigen Halbleitermaterialien, wobei die vorstehenden Indizes für alle Gruppe III Elemente in der Summe stets 1 ergeben und wobei die vorstehenden Indizes für alle Gruppe V Elemente in der Summe ebenfalls stets 1 ergeben.

Die Grundlage der Erfindung ist eine neuartige Kombination von vorhandenen Halbleitermaterialien und deren Weiterentwicklungen, um eine optimale Pufferschicht bzw. Anpassungsschicht für die Integration von III/V Bauelemente und insbesondere Kanalschichten auf Siliziumsubstrat zu realisieren.

Die Besonderheit der Erfindung liegt in der Realisierung einer Phosphor(P)-basierten und Arsen(As)-armen oder auch As-freien Pufferschicht, die zugleich durch die Beimischung von Aluminium (Al) auf seitens der Gruppe III im III/V Halbleitermischkristall die Materialeigenschaft einer relativ großen elektronischen Bandlücke besitzt und auf der Pufferoberfläche die Gitterkonstante der n-Kanalschicht mit möglichst geringer Versetzungsdefektdichte aufweist.

Die Erfindung weist drei entscheidende Vorteile gegenüber bestehender Integrationskonzepte auf:
1. Die Gitterkonstanten von (AlGa)P und Silizium unterschieden sich nur minimal. Dementsprechend können dünne (BAlGa)(NP)-Schichten mit niedriger Bor- oder Stickstoff-Konzentration ohne die Ausbildung von Fehlversetzungen epitaktisch auf (001) Siliziumsubstrat abgeschieden werden. Verfahrenstechnische Herausforderungen bei der monolithischen Verbindung von III/V Halbleitermischkristallen und Silizium aufgrund der unterschiedlichen Kristalleigenschaften beider Materialien, wie z.B. atomare Bindungseigenschaften und Gitterbasis, werden bei dem Wachstum dieser ersten dünnen III/V Halbleiterschicht gelöst. Erst im nächsten Schritt wird durch die gezielte Zumischung von Antimon und Indium die Gitterkonstante vergrößert und die Ausbildung von Fehlversetzungen kontrolliert initiiert.
   Durch die Verwendung eines defektfreien Templates kann somit die Gesamtschichtdicke der III/V-Pufferschicht deutlich reduziert werden, was wiederum entscheidend für die Kompatibilität zum bestehenden CMOS-Prozess ist. Des Weiteren sind dünnere Schichten kostengünstiger in der Produktion.
2. Die Bandlücke ist eine charakteristische Halbleitermaterialeigenschaft abhängig von der Materialzusammensetzung des III/V Kristalls und dessen Verspannungszustandes. Da die Bandlücke des III/V Materials der n-Kanalschicht vorwiegende klein ist, ergibt sich an der Berührungsfläche zwischen der Pufferschicht und der n-Kanalschicht ein großer Hetero-Offset im Leitungs- und/oder Valenzband der elektronischen Bandstruktur, wenn die Pufferschicht eine vergleichsweise große Bandlücke besitzt. Ein großer Offset im Leitungsband ist wiederum sehr vorteilhaft für die Funktionalität eines n-Kanal-Transistor. In dieser Erfindung wird insbesondere ein großer Hetero-Offset zur n-Kanalschicht realisiert.
3. n-Kanal-Materialsysteme mit optimalen Eigenschaften für das Bauelement enthalten häufig Arsen. Diese Kanalschichten sind jedoch sehr dünn im Vergleich zur Pufferschicht, daher ist es entscheidend insbesondere die Arsen-Konzentration in den dicken Pufferschichten zu vermindern. Die Anwendung eines Phosphor-basierten Puffers ermöglicht erstmals eine deutliche Reduktion von Arsenhaltigen Verbindung in der industriellen Produktion. Damit können die Kosten der aufwendigen Entsorgung von arsenhaltigen Abfallprodukten drastisch gesenkt werden.

In diesem Integrationskonzept wird außerdem ausgenutzt, dass bereits dünne (30-60 nm) Bor-Aluminium-Gallium-Nitrid-Phosphid ((BAlGa)(NP)) Schichten defekt-frei und ohne Kristallpolaritäts-Unordnung auf exakt-orientiertes (001) Silizium Substrat abgeschieden werden können. Dadurch kann die notwendige Pufferschichtdicke deutlich reduziert werden.

Dieses (BGaAl)(NP)-Si-Template wird somit als Vorlage für die Erfindung verwendet. Im Folgenden ist der Puffer in der Ausführungsform mit zwingend eingerichteten Schichten C) bis E) in drei Schichtpakete (1-3 bzw. Schichten C) bis E)) unterteilt:
1. Das erst Schichtpaket (Relaxationsschicht C) auf dem Template besteht vorzugsweise aus unterschiedlichen Einzelschichten, kann jedoch auch aus einer Schicht bestehen. Die Zusammensetzung dieser (BAlGaIn) (SbP) Einzelschichten wird so variiert, dass sich viele Fehlversetzungsdefekte bilden und die Gitterkonstante systematisch vergrößert wird. Des Weiteren können spezielle Ausheizverfahren angewendet werden, um die Ausbildung von Fehlversetzungen zu begünstigen. Entscheidend ist, dass die realisierte Gitterkonstante an der Oberfläche des ersten Schichtpaketes der Zielgitterkonstante für die Integration der Kanalschicht entspricht.
2. In dem zweiten Schichtpaket (Schicht D)) wird eine Fehlversetzungs-Blockier-Schicht realisiert. Diese Blockier-Schicht kann aus einer oder mehreren (BAlGaIn) (PSbN) Einzelschichten mit unterschiedlicher Zusammensetzung bestehen. Diese (BAlGaIn) (PSbN) Schichten soll verhindern, das Fehlversetzungen aus dem ersten Schichtpaket in die oberen III/V-Schichten (Schichtpaket 2 und 3 sowie die Kanalschicht) gelangen. Hierbei wird gezielt der Verspannungszustand der Einzelschichten variiert. Es sollen jedoch keine weiteren Fehlversetzungen erzeugt werden, dementsprechend werden diese Einzelschichten pseudomorph verspannt abgeschieden.
3. Im dritten Schichtpaket (Hetero-offset, Schicht E)) wird die optimale Bandlücke als auch der optimal Hetero-offset für die Integration der Kanalschicht realisiert. Dieses letzte Schichtpaket kann wiederum aus einer oder mehreren (BAlGaIn) (PSbNAs)-Schichten bestehen. Während die ersten beiden Schichtpakete Arsen-frei sind, kann dieses letzte Schichtpaket eine dünne Arsen-haltige Schicht einschließen. Diese Schicht ist jedoch vergleichsweise dünn (<50nm), wodurch der deutliche Vorteil dieser Erfindung bzgl. der Arsen-armen Produktion immer noch erhalten bleibt.

Im Einzelnen sind die folgenden Varianten der Erfindung bevorzugt.

Die Schichten C), D) und E) können in ihren Zusammensetzungen mit der Maßgabe gewählt sein, dass die Gitterkonstante einer der Schichten D) und/oder E) und/oder der der Schicht A) oder B) abgewandten Seite der Schicht C) im wesentlichen der Gitterkonstanten der Schicht F) entspricht.

Die Schicht A) ist auf der der Schicht B) oder C) zugewandten Seite vorzugsweise eine Si (001) Oberfläche eines Si Einkristalls.

Die einzelnen Schichten weisen vorzugsweise die folgenden Merkmale auf.

Die Schicht B) kann eine Dicke von 5-100 nm, insbesondere 30-80 nm, beispielsweise 60 nm, und/oder eine p- oder n-Dotierkonzentration von 1*10¹⁵-1*10²¹ cm⁻³, insbesondere 1*10¹⁵-1*10¹⁷ cm⁻³, beispielsweise 3*10¹⁵ cm⁻³, aufweisen. Vorzugsweise weist sie eine der folgenden Zusammensetzungen auf: z=v=1, x=y=t=0 oder y=v=1, x=z=t=0 oder x=0,01-0,1, y=0,90-0,99, z=t=0, v=1 oder x=0,01-0,1, z=0,90-0,99, y=t=0, v=1 oder t=0,01-0,1, v=0,90-0,99, y=x=0, z=1. Beispielsweise handelt es sich um GaP.

In der Schicht C) kann w und/oder u von der der Schicht A) oder B) zugewandten Seite zur auf der der Schicht A) oder B) abgewandten Seite monoton steigend oder fallend sein (sofern w und/oder u auf der der Schicht A) oder B) zugewandten Seite kleiner oder größer als auf der abgewandten Seite ist). Hierbei meint der Begriff "monoton steigend/fallend" einerseits in mathematischer Strenge "streng monoton steigend/fallend", betrachtet als Funktion von w und/oder u in einer Richtung einer Ortskoordinate, welch orthogonal zur Oberfläche der Schicht A) oder B) verläuft. Beispiele hierfür sind linear, exponentiell oder jede andere beliebige monotone Funktion. Der Begriff kann aber auch Funktionen umfassen, in welchen der Wert von w und/oder u in Abhängigkeit vom Ort teilweise konstant sein kann. Ein Beispiel hierfür ist eine (ansteigende oder abfallende) Stufenfunktion, welche sich dann einstellt, wenn die Schicht C) in Teilschichten hergestellt wird. Grundsätzlich ist jedoch nicht ausgeschlossen, dass w und/oder u innerhalb der Schicht C) auch in Teilbereichen in einem ortsabhängigen Konzentrationsverlauf wechselnde Vorzeichen der Steigung aufweist. Insbesondere ist es auch möglich, dass die Funktion w bzw. u in Abhängigkeit von besagter Ortskoordinate Maxima oder Minima durchläuft, deren Maximal- bzw. Minimalwerte auch höher bzw. niedriger als die Werte von w bzw. u an den beiden Seiten der Schicht C) sein können. Es ist aber auch möglich, dass die Maximal- bzw. Minimalwerte zwischen den Werten von w bzw. u an den beiden Seiten der Schicht C) sein können. Die Schicht C kann jedoch auch aus einer Einzelschicht mit einer konstanten Zusammensetzung bestehen.

Wie bereits angesprochen, kann die Schicht C) aus einer Mehrzahl von Teilschichten, insbesondere 1-30 Teilschichten, vorzugsweise 2-10 Teilschichten, beispielsweise 6 Teilschichten, gebildet sein, wobei w innerhalb einer Teilschicht wiederum variabel oder konstant sein (in Richtung orthogonal zur Oberfläche der Schicht A) oder B)). Die Schicht C) kann eine Dicke von 1-500 nm, insbesondere 100-400 nm, beispielsweise 300 nm, aufweisen. Teilschichten können jeweils, gleich oder verschieden, eine Dicke von 5 bis 500 nm, insbesondere 10 bis 100 nm, beispielsweise 10 bis 60 nm, aufweisen. Die Schicht C) bzw. deren Teilschichten, teilweise oder alle, kann eine p- oder n-Dotierkonzentration von 10¹⁵-10²¹ cm⁻³ aufweisen, aber auch undotiert sein. Die Schicht C) oder deren Teilschichten (gleich oder verschieden) weist vorzugsweise eine der folgenden Zusammensetzungen auf: y=1, x=z=u=0, v=1-w oder x=z=0, y=1-u, v+w=1. Beispiele sind AlPᵥSb_{w} und Al_{y}InᵤP oder Al_{y}InᵤPᵥSb_{w}. Letztgenannte Schicht empfiehlt sich insbesondere als vorletzte Teilschicht innerhalb einer Teilschichten aus ansonsten Al_{y}InᵤP aufweisenden Teilschichten, bezogen auf die darüber liegende nächste Schicht. Diese vorletzte Teilschicht kann beispielsweise w=0,08 und v=0,92 aufweisen.

Die Schicht D) wird typischerweise eine Dicke von 1-150 nm aufweisen und/oder undotiert und/oder eine p- oder n-Dotierkonzentration von 10¹⁵-10²¹ cm⁻³ aufweisen. Sie kann aus einer einzelnen Schicht oder einer Mehrzahl von (gleichen oder verschiedenen) Teilschichten, insbesondere 1-10 Schichten, vorzugsweise 2-5 Schichten, beispielsweise 2, gebildet sein. Die Schichtdicken von Teilschichten können im Bereich 1 bis 150 nm, beispielsweise 5 bis 100 nm, liegen. Die Schicht D) oder deren Teilschichten (gleich oder verschieden) weisen vorzugsweise eine der folgenden Zusammensetzungen auf: x=0-0,1, y=0,9-1, v=0-0,7, w=0,3-1, z=u=t=0 oder u=1, w=0-0,5, v=0,5-1, t=0-0,1, x=y=z=0 oder y=1, v=0-0,7, w=0,3-1, t=0-0,1, x=z=u=0 oder u=0,9-1, x=0-0,1, v=0,5-1, w=0-0,5, y=z=t=0.

Die Schicht E) oder deren (beispielsweise 2 bis 5) Teilschichten kann eine Dicke von 5-200 nm, insbesondere 10-100nm oder 10 bis 50nm, aufweisen. Es können 1 bis 10, vorzugsweise 2 bis 5, beispielsweise 2, Teilschichten eingerichtet sein, von gleicher oder verschiedener Zusammensetzung und/oder Dicke der Teilschichten (Dicke Teilschichten: 5-200 nm). Sie oder ihre Teilschichten können undotiert und/oder eine p- oder n-Dotierkonzentration von 10¹⁵-10²¹ cm⁻³ aufweisen. Die Schicht E) bzw. ihre Teilschichten (gleich oder verschieden) können vorzugsweise eine der folgenden Zusammensetzungen aufweisen: y=1, v=0,2-0,5, w=0,5-0,8, x=z=u=t=r=0 oder y=1, w=0,4-0,8, r=0,2-0,6, x=z=u=v=t=0.

Dotierung, sofern eingerichtet, können mit den Elementen Si, Te, S, Zn, Mg, Be und/oder C erfolgen. Dotierungsreagenzien zum Einsatz in folgend beschriebenen Verfahren sind beispielsweise Diethyltellurium, Dimethylzink, Diethylzink, Ditertiarybutylsilan, Silan, Ditertiarybutylsulphid, Bis-Cyclopentadienyl-Magnesium, oder Tetrabrommethan.

Die Erfindung umfasst des Weiteren ein Verfahren zur Herstellung einer monolithischen integrierten Halbleiterstruktur nach einem der Ansprüche 1 bis 15, wobei auf eine Schicht A),optional eine Schicht B) epitaktisch aufgewachsen wird, auf die Schicht A) oder B) eine Schicht C) epitaktisch aufgewachsen wird, auf die Schicht C) optional eine Schicht D) und/oder E) epitaktisch aufgewachsen wird, auf die Schicht C) oder D) oder E) die Schicht F) epitaktisch aufgewachsen wird. Eine Schicht oder mehrere der Schichten A), B), C), D), E), und/oder F) können p- oder n-dotiert sein aber auch insbesondere undotiert sein.

Im Einzelnen kann ein erfindungsgemäßes Verfahren die folgenden Verfahrensschritte umfassen: eine Substrat enthaltend die Schicht A) wird in eine Epitaxie-Apparatur, insbesondere eine Metallorganische-Gasphasen-Epitaxie(MOVPE)-Apparatur, eingebracht, ein Trägergas, vorzugsweise Stickstoff oder Wasserstoff, wird mit Edukten in definierten Konzentrationen nach Maßgabe der vorgegebenen Zusammensetzung einer Schicht A), B), C), D), und E), ggf. auch F), oder deren Teilschichten beladen, das beladene Trägergas wird über die Oberfläche des auf eine Temperatur im Bereich von 300°C bis 800 °C, insbesondere 400 °C bis 625 °C im Falle der Schichten C) und D) oder deren Teilschichten oder 525 °C bis 725°C im Falle der Schicht E) oder deren Teilschichten, erhitzten Substrates bzw. auf die Oberfläche der obersten Schicht auf dem Substrat für eine definierte Expositionsdauer geleitet, wobei Gesamtkonzentation der Edukte und Expositionsdauer mit der Maßgabe aufeinander abgestimmt sind, dass die Halbleiterschicht mit einer vorgegebenen Schichtdicke auf der Oberfläche des Substrats bzw. der Oberfläche der obersten Schicht auf dem Substrat epitaktisch gebildet wird.

Die Schicht C) kann in Teilschichten aufgewachsen werden und wobei zwischen dem Aufwachsen von zwei Teilschichten und/oder nach dem Aufwachsen der letzten Teilschicht ein Ausheizen des Substrats auf 550 °C bis 750 °C, insbesondere auf 600 °C bis 725 °C, erfolgen kann.

Als Edukte können eingesetzt werden: C1-C5 Trialkylgallium, insbesondere Triethylgallium (Ga(C₂H₅)₃), Tritertiarybutylgallium und/oder Trimethylgallium (Ga(CH₃)₃) als Ga-Edukt, Diboran (B₂H₆) oder C1-C5 Trialkylboran, insbesondere Triethylboran (B(C₂H₅)₃) und Tritertiarybutylboran und/oder Boran-Amin-Addukte wie Dimethylaminoboran als B-Edukt, Alan-Amin-Addukte wie z.B. Dimethylethylaminalan oder C1-C5 Trialkylalluminium, insbesondere Trimethylalluminium (Al(CH₃)₃) und Tritertiarybutylaluminium als Al-Edukt, C1-C5 Trialkylindium, insbesondere Trimethylindium (In(CH₃)₃) als In-Edukt, Phosphin (PH₃) und/oder C1-C5 Alkylphosphin, insbesondere Tertiärbutylphosphin (TBP) (t-(C₄H₉)-PH₂) as P-Edukt, Arsin (AsH₃) und/oder C1-C5 Alkylarsin, insbesondere Tertiärbutylarsin (TBAs) (t-(C₄H₉)-AsH₂) und/oder Trimethylarsin (As(CH₃)₃) als As-Edukt, C1-C5 Trialkylantimon, insbesondere Triethylantimon (Sb(C₂H₅)₃) und/oder Trimethylantimon (Sb(CH₃)₃) als Sb-Edukt, Ammoniak (NH₃), Mono(C1-C8)alkylhydrazin, insbesondere Tertiärbutylhydrazin (t-(C₄H₉)NH₂) und/oder 1,1-Di(C1-C5)alkylhydrazin, insbesondere 1,1-Dimethylhydrazin ((CH₃)₂-N-NH₂) als N-Edukt, wobei C3-C5 Alkylgruppen linear oder verzweigt sein können.

Edukte für die Dotierung sind: Diethyltellurium (DETe), Dimethylzink (DMZn), Diethylzink (DEZn), Ditertiarybutylsilan (DitButSi), Silan, Ditertiarybutylsulphid, Bis-Cyclopentadienyl-Magnesium, Tetrabrommethan.

Der Gesamtdruck von Trägergas und Edukten kann im Bereich von 10 bis 1000 hPa, insbesondere 50 bis 500 hPa, eingestellt sein, wobei das Verhältnis der Summe der Partialdrucke der Edukte zum Partialdruck des Trägergases zwischen 1*10E-6 bis 0,5 liegt, und wobei die Abscheiderate 0,01 bis 10 *µ*m/h, insbesondere 0,05 bis 5 *µ*m/h, beträgt.

Die Erfindung umfasst also auch ein neues Epitaxieverfahren, bei dem der Einsatz von metallorganischen Gruppe-V-Ausgangssubstanzen die Anwendung von extrem niedrigen Abscheide-Temperaturen erlaubt. Niedrige Kristallwachstumstemperaturen sind besonders wichtig, um die Gitterfehlanpassung in einer sehr dünnen Pufferschicht realisieren zu können. Da diese metallorganischen Gruppe-V- Precursoren wie TBAs und TBP bei Raumtemperatur flüssig sind, ist die Handhabung in der Produktion wesentlich sicherer als die Verwendung der üblichen gasförmigen und hoch-giftigen Ausgangsubstanzen Arsin und Phosphin. Außerdem können die Wartungszeiten von Epitaxie-Maschinen reduziert werden, da parasitäre Ablagerungen im Abgas-Rohsystem deutlich reduziert werden. Insgesamt bietet dieses neuartige Epitaxieverfahren damit deutliche wirtschaftliche Vorteile in der Massenproduktion.

Schließlich betrifft die Erfindung die Verwendung einer erfindungsgemäßen Halbleiterstruktur zur Herstellung eines III/V Halbleiterbauelementes wie z.B. ein III/V Kanal Transistor auf einem Siliziumsubstrat, wobei der III/V Kanal des Transistors vorzugsweise die Schicht F) bildet und epitaktisch aufgewachsen wird, sowie eine Halbleiterstruktur erhältlich mit einem erfindungsgemäßen Verfahren nach einem der Ansprüche.

Die Ausführungen zur erfindungsgemäßen Halbleiterstruktur sind analog auch auf das Verfahren und umgekehrt anwendbar.

Von selbstständiger Bedeutung ist auch eine Kombination der Schichten C), D) und E) gemäß der Ansprüche miteinander als Pufferschicht, und zwar unabhängig von den Merkmalen der weiteren Schichten gemäß der Ansprüche.

Im Folgenden wird die Erfindung anhand von nicht beschränkenden Ausführungsbeispielen näher erläutert.

### Beispiel 1.1: Schicht C), erste Variante

In diesem Beispiel und in allen folgenden wird ein CCS (close couple showerhead)-Crius-MOVPE Anlage der Firma Aixtron verwendet.

Das zu verwendende Template besteht aus einer 60nm dicken GaP auf einem (001) exakt-orientierten Siliziumsubstrat. Im ersten Schritt wird das Template bei 675°C für 5 min unter Tertiärbutylphosphine (TBP) Stabilisierung ausgeheizt. Der Reaktordruck beträgt 100 mbar, der Gesamtfluss 48 1/min und der TBP-Fluss ist 1E-3 mol/min. Reaktordruck und Gesamtfluss werden im gesamten Prozess konstant gehalten.

Im folgenden Schritt wird die Wafertemperatur für das Wachstum der Relaxationsschicht(Schicht C)) auf 500°C erniedrigt und die Mol-Flüsse von Al, P und Sb für die Abscheidung von AlPSb im eingestellt. Der Wachstumsmodus kann kontinuierlich sein, vorzugsweise mittels Fluss-Modulations-Epitaxie (Flow rate modulation epitaxy (FME)) oder mittels atomare Schichtabscheidung (atomic layer deposition (ALD)). Entsprechend wird der Trimethylaluminium(TMAl)-Mol-Fluss so eingestellt, dass in einer Sekunde eine Monolage Al die Substratoberfläche belegt. Das (TESb+TBP)/TMAl-Verhältnis (TESb = Triethylantimon) beträgt 20 während das TESb/(TBP+TESb)-Verhältnis so angepasst wird, das in jeder Schicht die gewünschte Zusammensetzung der Gruppe V Elemente realisiert wird.

Insgesamt setzt sich das erste Schichtpaket (Relaxationsschicht) aus 6 Einzelschichten zusammen. Die Einzelschichtdicke ist jeweils 50nm. Jede Schicht wird im FME-Modus abgeschieden und danach ein Ausheizschritt durchgeführt. Nach dem Ausheizen wird die Wafertemperatur wieder auf 500°C erniedrigt und die Mol-Flüsse für die nächste Abscheidung verfahren. Das Ausheizen findet unter einer TBP-Stabilisierung statt, während der Precursor TESb nur für die Abscheidung in den Reaktor geschaltet wird. Das Ausheizen wird bei einer Temperatur von 675°C für 1min durchgeführt.

Die sechs AlSbP-Einzelschichten besitzen folgende Sb-Konzentration:
1) 15%
2) 30%
3) 45%
4) 60%
5) 68%
6) 60%

Mit dem letzten Ausheizschritt ist die Abscheidung der Relaxationsschicht abgeschlossen. Die Verfahrensparameter sind im Einzelnen wie folgt:
Gesamtgasfluss 481/min, Reaktordruck 100 mbar,
Wafertemperatur 500 °C, Ausheiztemperatur 675°C,
Ausheizdauer 1min.

### Beispiel 1.2: Schicht C), zweite Variante

In diesem Beispiel und in allen folgenden wird ein CCS-Crius-MOVPE Anlage der Firma Aixtron verwendet.

Das zu verwende Template besteht aus einer 60nm dicken GaP auf einem (001) exakt-orientierten Siliziumsubstrat. Im ersten Schritt wird das Template bei 675°C für 5 min unter Tertiärbutylphoshine (TBP) Stabilisierung ausgeheizt. Der Reaktordruck beträgt 100 mbar, der Gesamtfluss 48 1/min und der TBP-Fluss ist 1E-3 mol/min. Reaktordruck und Gesamtfluss werden im gesamten Prozess konstant gehalten.

Im folgenden Schritt wird die Wafertemperatur für das Wachstum der Relaxationsschicht (Schicht C)) auf 500°C erniedrigt und die Mol-Flüsse von Al, P und Sb für die Abscheidung von AlPSb im eingestellt. Der Wachstumsmodus kann kontinuierlich sein, vorzugsweise mittels Fluss-Modulations-Epitaxie (Flow rate modulation epitaxy (FME)) oder mittels atomare Schichtabscheidung (atomic layer deposition (ALD)). Entsprechend wird der Trimethylaluminium(TMA1)-Mol-Fluss so eingestellt, dass in einer Sekunde eine Monolage Al die Substratoberfläche belegt. Das (TESb+TBP)/TMA1-Verhältnis (TESb = Triethylantimon) beträgt 20 während das TESb/(TBP+TESb)-Verhältnis so angepasst wird, das in jeder Schicht die gewünschte Zusammensetzung der Gruppe V Elemente realisiert wird.

Insgesamt setzt sich das erste Schichtpaket (Relaxationsschicht) aus 5 Einzelschichten zusammen. Alle ternären Einzelschichtdicken sind 50nm dicke, nur die binäre Einzelschicht AlSb wird in der Dicke so gewählt, dass das Ausheizen eine Teilrelaxation bis zur gewünschten Gitterkonstante des Halbleitermaterials der n-Kanal-Schicht bewirkt. Das bedeutet in diesem Beispiel, dass die AlSb-Schicht nicht komplett relaxiert ist und immer noch eine Gitterkonstant kleiner als AlSb, aber identisch mit der n-Kanal-Schicht aufweist. Jede Schicht wird im FME-Modus abgeschieden und danach ein Ausheizschritt durchgeführt. Nach dem Ausheizen wird die Wafertemperatur wieder auf 500°C erniedrigt und die Mol-Flüsse für die nächste Abscheidung verfahren. Das Ausheizen findet unter einer TBP-Stabilisierung statt, während der Precursor TESb nur für die Abscheidung in den Reaktor geschaltet wird. Das Ausheizen wird bei einer Temperatur von 675°C für 1min durchgeführt.

Die sechs AlSbP-Einzelschichten werden in folgender Sequenz abgeschieden und besitzen folgende Sb-Konzentration:
1) 25%
2) 50%
3) 75%
4) 100%
5) 60%

Mit dem letzten Ausheizschritt ist die Abscheidung der Relaxationsschicht abgeschlossen. Die Verfahrensparameter sind im Einzelnen wie folgt:
Gesamtgasfluss 481/min, Reaktordruck 100 mbar,
Wafertemperatur 500 °C, Ausheiztemperatur 675°C,
Ausheizdauer 1min.

### Beispiel 1.3: Schicht C), dritte Variante

In diesem Beispiel und in allen folgenden wird ein CCS-Crius-Reaktor der Firma Aixtron verwendet.

Das zu verwende Template besteht aus einer 60nm dicken GaP auf einem (001) exakt-orientierten Siliziumsubstrat. Im ersten Schritt wird das Template bei 675°C für 5 min unter Tertiärbutyl (TBP) Stabilisierung ausgeheizt. Der Reaktordruck beträgt 100 mbar, der Gesamtfluss 48 1/min und der TBP-Fluss ist 1E-3 mol/min. Reaktordruck und Gesamtfluss werden im gesamten Prozess konstant gehalten.

Im folgenden Schritt wird die Wafertemperatur für das Wachstum der Relaxationsschicht (Schicht C)) auf 500°C erniedrigt und die Mol-Flüsse von Al, In, P (bzw. Sb) für die Abscheidung von AlInPSb eingestellt. Der Wachstumsmodus kann kontinuierlich sein, vorzugsweise mittels Fluss-Modulations-Epitaxie (Flow rate modulation epitaxy (FME)) oder mittels atomare Schichtabscheidung (atomic layer deposition (ALD)). Entsprechend wird die Summe der Gruppe III Mol-Flüsse, hier TMAl und Trimethylindium (TMIn), so eingestellt, dass in einer Sekunde eine Monolage Gruppe III Elemente die Substratoberfläche belegt. Das TMAl/(TMAl+TMIn) Verhältnis sowie das TESb/(TBP+TESb)- Verhältnis wird so angepasst, das in jeder Schicht die gewünschte Zusammensetzung der Gruppe III und Gruppe V Elemente realisiert wird. Insgesamt setzt sich das erste Schichtpaket (Relaxationsschicht) aus 6 Einzelschichten zusammen. Die Einzelschichtdicke ist jeweils 50nm. Jede Schicht wird im FME-Modus abgeschieden und danach ein Ausheizschritt durchgeführt. Nach dem Ausheizen wird die Wafertemperatur wieder auf 500°C erniedrigt und die Mol-Flüsse für die nächste Abscheidung verfahren. Das Ausheizen findet unter einer TBP-Stabilisierung statt, während der Precursor TESb nur für die Abscheidung in den Reaktor geschaltet wird. Das Ausheizen wird bei einer Temperatur von 650°C für 1min durchgeführt.

Die sechs AlInP-Einzelschichten besitzen folgende In-Konzentration:
1) 25%
2) 50%
3) 75%
4) 100%
5) 100%, wobei in dieser Schicht auch Sb eingebaut wird (w=0,08, v=0,92)
6) 100%

Mit dem letzten Ausheizschritt ist die Abscheidung der Relaxationsschicht abgeschlossen. Die Verfahrensparameter sind im Einzelnen wie folgt:
Gesamtgasfluss 481/min, Reaktordruck 100 mbar,
Wafertemperatur 500 °C, Ausheiztemperatur 675°C,
Ausheizdauer 1min.

### Beispiel 2.1: Schicht D, erste Variante

Für das Wachstum der Fehlversetzungs-Blockier-Schicht wird die Wafertemperatur auf 575°C eingestellt. Der TMAl-Mol-Fluss wird für einen kontinuierlichen Wachstumsmodus (normale Abscheidung) von 2*µ*m/h bei 575°C angepasst. Außerdem wird der TEB-Fluss so eingestellt, dass 2% Bor eingebaut werden.

Die Fehlversetzungs-Blockier-Schicht setzt sich aus 2 Schichten zusammen, die ohne Wachstumsunterbrechung oder einem Ausheizschritt nacheinander abgeschieden werden. Die Zusammensetzung (Prozente jeweils bezogen auf 100% Gruppe III oder Gruppe V Elemente) und Schichtdicke ist wie folgend:
1) 50nm, B2% Al98% P40% Sb60%
2) 50nm, B2% Al98% P34.1% Sb65.9%

Wachstumsrate 2*µ*m/h (normaler Modus), Gesamtgasfluss 481/min, Reaktordruck 100 mbar, Wafertemperatur 575 °C. Schicht 1) ist der Schicht C) zugewandt.

### Beispiel 2.2: Schicht D, zweite Variante

Es wird in 2.2 zum Beispiel 2.1 analoger Weise vorgegangen. Die Fehlversetzungs-Blockier-Schicht setzt sich aus 2 Schichten zusammen, die ohne Wachstumsunterbrechung oder einem Ausheizschritt nacheinander abgeschieden werden. Die Gruppe III Atome bestehen in diesem Beispiel nur aus Indium. Anstelle von TEB wird der 1,1-Dimethylhydrazinfluss (UDMHy) so eingestellt, dass 2% Stickstoff auf seitens von Gruppe V eingebaut werden.

Die Zusammensetzung und Schichtdicke ist wie folgend:
1) 50nm, N2% P98% In100%
2) 50nm, N2% Sb5,9% P92,1% In100%

Schicht 1) ist der Schicht C) zugewandt.

### Beispiel 3.1: Schicht E), erste Variante

Das letzte Schichtpaket (der Pufferschicht) besteht aus einer ternären AlPSb-Schicht mit einer Dicke von 50nm. Die Wachstums-Temperatur und Reaktordruck und Flusseinstellungen sind identisch mit den Parametern für die Abscheidung der Fehlversetzungs-Blockier-Schicht. Die Zusammensetzung von 100% Al, 40% P und 60% Sb ergeben die gezielte Gitterkonstante für die Integration der n-Kanalschicht. Einstellungen, wie in Beispiel 2.1, jedoch Wachstumsrate 1 *µ*m/h.

### Beispiel 3.2: Schicht E), zweite Variante

Das letzte Schichtpaket (der Pufferschicht) besteht hier aus einer ternären AlPSb-Schicht gemäß Beispiel 3.1 mit einer Dicke von 10nm als der Schicht D) zugewandte Teilschicht und einer 40nm dicken Teilschicht der Zusammensetzung AlAs_{0,56}Sb_{0,44}. Die Wachstums-Temperaturen und Reaktordruck und Flusseinstellungen sind identisch mit den Parametern für die Abscheidung der Fehlversetzungs-Blockier-Schicht, jedoch ist die Wachstumsrate 1 *µ*m/h

## Patentansprüche

1. Monolithische integrierte Halbleiterstruktur enthaltend den folgenden Schichtaufbau:
A) eine Trägerschicht auf Basis dotiertem oder undotiertem Si,
B) optional einer Schicht mit der Zusammensetzung BₓAl_{y}Ga_{z}NₜPᵥ, wobei x=0-0,1, y=0-1, z=0-1, t=0-0,1 und v=0,9-1,
C) eine Relaxationsschicht mit der Zusammensetzung BₓAl_{y}Ga_{z}InᵤPᵥSb_{w}, wobei x=0-0,1, y=0-1, z=0-1, u=0-1, v=0-1 und w=0-1, wobei w und/oder u auf der der Schicht A) oder B) zugewandten Seite kleiner, gleich, oder größer als auf der der Schicht A) oder B) abgewandten Seite und innerhalb der Relaxationsschicht variiert oder konstant ist, und wobei v=1-w und/oder y=1-u-x-z ist,
D) optional einer Schicht zur Blockierung von Fehlversetzungen mit der Zusammensetzung BₓAl_{y}Ga_{z}InᵤPᵥSb_{w}Nₜ, wobei x=0-0,1, y=0-1, z=0-1, u=0-1, v=0-1, w=0-1 und t=0-0,1,
E) optional einer Schicht zum Hetero-offset mit der Zusammensetzung BₓAl_{y}Ga_{z}InᵤPᵥSb_{w}NₜAsᵣ wobei x=0-0,1, y=0-1, z=0-1, u=0-1, v=0-1, w=0-1, t=0-0,1 und r=0-1, und
F) ein beliebiges, vorzugsweise Gruppe III/V, Halbleitermaterial, oder eine Kombination von mehreren veschiedenen beliebigen Halbleitermaterialien,
wobei die vorstehenden stöchiometrischen Indizes für alle Gruppe III Elemente in der Summe stets 1 ergeben und wobei die vorstehenden stöchiometrischen Indizes für alle Gruppe V Elemente in der Summe ebenfalls stets 1 ergeben.

2. Halbleiterstruktur nach Anspruch 1, wobei die Schichten C), D) und E) in ihren Zusammensetzungen mit der Maßgabe gewählt sind, dass die Gitterkonstante einer der Schichten D) und/oder E) und/oder der der Schicht A) oder B) abgewandten Seite der Schicht C) im wesentlichen der Gitterkonstanten der Schicht F) entspricht, und/oder
wobei die Schicht A) auf der der Schicht B) oder C) zugewandten Seite eine Si 001 Oberfläche eines Si Einkristalls ist, und/oder
wobei die Schicht B) eine Dicke von 20-100 nm und/oder eine p- oder n-Dotierkonzentration von 1*10¹⁵-1*10²¹ cm⁻³ aufweist.

3. Halbleiterstruktur nach einem der Ansprüche 1 oder 2, wobei die Schicht B) eine der folgenden Zusammensetzungen aufweist:
z=v=1, x=y=t=0 oder
y=v=1, x=z=t=0 oder
x=0,01-0,1, y=0,90-0,99, z=t=0, v=1 oder
x=0,01-0,1, z=0,90-0,99, y=t=0, v=1 oder
t=0,01-0,1, v=0,90-0,99, y=x=0, z=1.

4. Halbleiterstruktur nach einem der Ansprüche 1 bis 3, wobei in der Schicht C) w und oder u auf der der Schicht A) oder B) zugewandten Seite kleiner als auf der der Schicht A) oder B) abgewandten Seite ist und in Richtung einer Ortskoordinate, welche orthogonal zu den Hauptflächen der Schicht C) steht, ein Maximum durchläuft, wobei w und oder u im Maximum optional größer als auf der der Schicht A) oder B) abgewandten Seite sein kann und/oder
wobei die Schicht C) aus einer Mehrzahl von Teilschichten, insbesondere 1-30 Schichten, vorzugsweise 2-10 Schichten, gebildet ist, wobei w und oder u innerhalb einer Teilschicht variabel oder konstant ist, und/oder
wobei die Schicht C) eine Dicke von 1-500 nm, insbesondere 100-400 nm, aufweist und/oder keine Dotierung oder eine p- oder n-Dotierkonzentration von 1*10¹⁵-1*10²¹ cm⁻³ aufweist, und/oder
wobei die Schicht C) oder deren Teilschichten eine der folgenden Zusammensetzungen aufweist:
y=1, x=z=u=0, v=1-w oder
x=z=0, y=1-u, v+w=1.

5. Halbleiterstruktur nach einem der Ansprüche 1 bis 4, wobei die Schicht D) eine Dicke von 1-150 nm aufweist und/oder undotiert und/oder eine p- oder n-Dotierkonzentration von 1*10¹⁵-1*10²¹ cm⁻³ aufweist und/oder
wobei die Schicht D) aus einer einzelnen Schicht oder einer Mehrzahl von Teilschichten, insbesondere 1-10 Schichten, vorzugsweise 2-5 Schichten, gebildet ist, und/oder
wobei die Schicht D) oder deren Teilschichten eine der folgenden Zusammensetzungen aufweist:
x=0-0,1, y=0,9-1, v=0-0,7, w=0,3-1, z=u=t=0 oder
u=1, w=0-0,5, v=0,5-1, t=0-0,1, x=y=z=0 oder
y=1, v=0-0,7, w=0,3-1, t=0-0,1, x=z=u=0 oder
u=0,9-1, x=0-0,1, v=0,5-1, w=0-0,5, y=z=t=0.

6. Halbleiterstruktur nach einem der Ansprüche 1 bis 5, wobei die Schicht E) eine Dicke von 5-200 nm, insbesondere 10-100nm, aufweist und/oder undotiert und/oder eine p- oder n-Dotierkonzentration von 1*10¹⁵-1*10²¹ cm⁻³ aufweist, und/oder
wobei die Schicht E) aus einer einzelnen Schicht oder einer Mehrzahl von Teilschichten, insbesondere 1-10 Schichten, vorzugsweise 2-5 Schichten, gebildet ist, und/oder
wobei die Schicht E) eine der folgenden Zusammensetzungen aufweist:
y=1, v=0,2-0,5, w=0,5-0,8, x=z=u=t=r=0 oder
y=1, w=0,4-0,8, r=0,2-0,6, x=z=u=v=t=0.

7. Verfahren zur Herstellung einer monolithischen integrierten Halbleiterstruktur nach einem der Ansprüche 1 bis 6,
wobei auf eine Schicht A)
optional eine Schicht B) epitaktisch aufgewachsen wird,
auf die Schicht A) oder B) eine Schicht C) epitaktisch aufgewachsen wird,
auf die Schicht C) optional eine Schicht D) und/oder E) epitaktisch aufgewachsen wird,
auf die Schicht C) oder D) oder E) die Schicht F) epitaktisch aufgewachsen wird.

8. Verfahren nach Anspruch 7, wobei eine Schicht oder mehrere der Schicht A), B), C), D), E), und/oder F) p- oder n-dotiert ist.

9. Verfahren nach Anspruch 7 oder 8 mit den folgenden Verfahrensschritten:
Eine Substrat enthaltend die Schicht A) wird in eine Epitaxie-Apparatur, insbesondere eine MOVPE-Apparatur, eingebracht,
ein Trägergas wird mit Edukten in definierten Konzentrationen nach Maßgabe der vorgegebenen Zusammensetzung einer Schicht A), B), C), D), und E), ggf. auch F), oder deren Teilschichten beladen,
das beladene Trägergas wird über die Oberfläche des auf eine Temperatur im Bereich von 300°C bis 800 °C, insbesondere 400 °C bis 625 °C im Falle der Schichten C) und D) oder deren Teilschichten oder 525 °C bis 725°C im Falle der Schicht E) oder deren Teilschichten, erhitzten Substrates bzw. auf die Oberfläche der obersten Schicht auf dem Substrat für eine definierte Expositionsdauer geleitet, wobei Gesamtkonzentation der Edukte und Expositionsdauer mit der Maßgabe aufeinander abgestimmt sind, dass die Halbleiterschicht mit einer vorgegebenen Schichtdicke auf der Oberfläche des Substrats bzw. der Oberfläche der obersten Schicht auf dem Substrat epitaktisch gebildet wird, wobei der epitaktische Wachstumsmodus kontinuierlich sein kann, vorzugsweise mittels Fluss-Modulations-Epitaxie (Flow rate modulation epitaxy (FME)) oder mittels atomare Schichtabscheidung (atomic layer deposition (ALD).

10. Verfahren nach Anspruch 9, wobei die Schicht C) in Teilschichten aufgewachsen wird und wobei zwischen dem Aufwachsen von zwei Teilschichten und/oder nach dem Aufwachsen der letzten Teilschicht ein Ausheizen des Substrats auf 550 °C bis 750 °C, insbesondere auf 600 °C bis 725 °C, erfolgt.

11. Verfahren nach Anspruch 9 oder 10, wobei als Edukte für den Aufbau der Schichten eingesetzt werden:
C1-C5 Trialkylgallium, insbesondere Triethylgallium (Ga(C₂H₅)₃), Tritertiarybutylgallium und/oder Trimethylgallium (Ga(CH₃)₃) als Ga-Edukt,
Diboran (B₂H₆) oder C1-C5 Trialkylboran, insbesondere Tritertiarybutylboran und Triethylboran (B(C₂H₅)₃) und/oder Boran-Amin-Addukte wie Dimethylaminoboran als B-Edukt,
Alan-Amin-Addukte oder C1-C5 Trialkylalluminium, insbesondere Trimethylalluminium (Al(CH₃)₃), Tritertiarybutylaluminium und/oder Dimethylethylaminalan als Al-Edukt,
C1-C5 Trialkylindium, insbesondere Trimethylindium (In(CH₃)₃) als In-Edukt,
Phosphin (PH₃) und/oder C1-C5 Alkylphosphin, insbesondere Tertiärbutylphosphin (t-(C₄H₉)-PH₂) as P-Edukt,
Arsin (AsH₃) und/oder C1-C5 Alkylarsin und/oder Trimethylarsin (As(CH₃)₃) insbesondere Tertiärbutylarsin (t-(C₄H₉)-AsH₂) als As-Edukt,
C1-C5 Trialkylantimon, insbesondere Triethylantimon (Sb(C₂H₅)₃) und/oder Trimethylantimon (Sb(CH₃)₃) als Sb-Edukt,
Ammoniak (NH₃), Mono(C1-C8)alkylhydrazin, insbesondere Tertiärbutylhydrazin (t-(C₄H₉)NH₂) und/oder 1,1-Di(C1-C5)alkylhydrazin, insbesondere 1,1-Dimethylhydrazin ((CH₃)₂-N-NH₂) als N-Edukt,
wobei C3-C5 Alkylgruppen linear oder verzweigt sein können, und
wobei als Edukte für die Dotierungen der Schichten eingesetzt werden: Diethyltellurium (DETe),
Dimethylzink (DMZn), Diethylzink (DEZn), Ditertiarybutylsilan (DitButSi), Silan, Ditertiarybutylsulphid, Bis-Cyclopentadienyl-Magnesium, Tetrabrommethan.

12. Verfahren nach einem der Ansprüche 9 bis 11,
wobei der Gesamtdruck von Trägergas und Edukten im Bereich von 10 bis 1000 hPa, insbesondere 50 bis 500 hPa, eingestellt ist, wobei das Verhältnis der Summe der Partialdrucke der Edukte zum Partialdruck des Trägergases zwischen 1*10E-6 bis 0,5 liegt, und wobei die Abscheiderate 0,01 bis 10 *µ*m/h, insbesondere 0,05 bis 5 *µ*m/h, beträgt.

13. Verwendung einer Halbleiterstruktur nach einem der Ansprüche 1 bis 6 zur Herstellung eines III/V Kanal Transistors oder andere III/V basierte Bauelemente wie Laser, Leuchtdiode, Detektor und Solarzelle auf einem Siliziumsubstrat.

14. Halbleiterstruktur erhältlich mit einem Verfahren nach einem der Ansprüche 7 bis 12.
